# EUROPEAN PATENT APPLICATION

(11) **EP 1 696 489 A2**
(43) Date of publication of application: **30.08.2006**
(21) Application number: 06250936.9
(22) Date of filing: 22.02.2006
(51) Int. Cl.: H01L 27/146

(54) **Solid-state imaging device**

(30) Priority: 23.02.2005 JP 2005047149
(71) Applicant: SHARP KABUSHIKI KAISHA, Osaka-shi, Osaka 545-8522 (JP)
(72) Inventor: Tsukamoto, Hiroaki, Yamatotakada-shi, Nara 635-0045 (JP); Hirosumi, Nobuhito, Fukuyama-shi, Hiroshima 721-0924 (JP); Yasudome, Takashi, Fukuyama-shi, Hiroshima 721-0907 (JP); Kinoshita, Kazuo, Nara-shi, Nara 630-8307 (JP)
(74) Representative: Brown, Kenneth Richard

(57) **Abstract**

A solid-state imaging device which has a wiring substrate 2, a solid-state image sensor 13 having a face opposite to a pixel area 14 fixed to the wiring substrate 2, and a transparent cover 17 fixed to the solid-state image sensor 13 through an adhesive layer 18 so as to oppose the pixel area 14 of the solid-state image sensor 13. The wiring substrate 2 has, on a side opposing the transparent cover 17, a cavity 3 being provided with plural connecting terminals 9. The solid-state image sensor 13 is fixed to a bottom face 5 of the cavity 3 in a state where the solid-state image sensor 13 falls into the cavity 3. The connecting terminals 9 of the cavity 3 are connected with connecting terminals 15 of the solid-state image sensor 13, respectively through a wiring 20 which falls into the cavity 3.

## Description

### BACKGROUND OF THE INVENTION

### 1. Field of the Invention

The present invention relates to a solid-state imaging device which is suitable as a component of a module for an optical device.

### 2. Description of Related Art

As a conventional solid-state imaging device, a solid-state imaging device disclosed in Japanese Patent Application Laid-Open No. 2004-296453 is well known.

In this prior art, a solid-state image sensor such as a CCD image sensor or a CMOS image sensor is provided on a wiring substrate in such a manner that a face thereof, which is opposite to a pixel area, is fixed to the wiring substrate. A transparent cover is fixed to an outward face of the pixel area through an adhesive layer so as to oppose the pixel area of the solid-state image sensor. Plural connecting terminals of the wiring substrate are connected with plural connecting terminals of the solid-state image sensor through wirings.

However, the aforementioned conventional solid-state imaging device has the following problems.

That is, since the wirings for connection between the plural connecting terminals of the wiring substrate and the plural connecting terminals of the solid-state image sensor are exposed, there is a possibility that the wirings are disadvantageously brought into contact with something at the time of transporting the solid-state imaging device or at the time of assembling the solid-state imaging device with another component. As a result, there arises a problem that the wirings are readily cut or the wirings are readily disconnected from the connecting terminals.

### BRIEF SUMMARY OF THE INVENTION

The present invention has been made in view of the aforementioned circumstances. It is therefore a main object of the present invention to provide a solid-state imaging device in which the wiring in the aforementioned conventional technique falls into a cavity of a wiring substrate, whereby the wiring can be prevented from being cut.

It is another object of the present invention to provide a solid-state imaging device in which connecting terminals of a wiring substrate are positioned at not a bottom face side but an opening side of a cavity, whereby a wiring connecting process can be readily carried out.

It is still another object of the present invention to provide a solid-state imaging device in which at least part of a transparent cover falls into a cavity of a wiring substrate, whereby the transparent cover can be protected.

It is yet another object of the present invention to provide a solid-state imaging device in which wirings can be protected by a sealant.

It is yet another object of the present invention to provide a solid-state imaging device in which an electronic component falls into a cavity of a wiring substrate, whereby the electronic component can be protected.

It is yet another object of the present invention to provide a solid-state imaging device in which wirings and an electronic component can be protected by a sealant.

In order to achieve the aforementioned objects, the present invention employs the following configurations.

A solid-state imaging device according to the present invention comprises: a wiring substrate; a solid-state image sensor fixed to the wiring substrate; and a transparent cover fixed to the solid-state image sensor so as to oppose a pixel area of the solid-state image sensor; and is characterized in that a cavity which is provided with, at an inner face thereof, plural connecting terminals is formed on one face of the wiring substrate, the solid-state image sensor is provided with plural connecting terminals, and is fixed to a bottom face of the cavity in a state where the solid-state image sensor falls into the cavity, and the plural connecting terminals provided in the cavity are connected with the plural connecting terminals provided on the solid-state image sensor, respectively through a wiring which is falls into the cavity.

According to the present invention, wirings fall into a cavity and are protected by a wiring substrate. Thus, it is possible to prevent cutting of the wiring and disconnection of the wiring from a connecting terminal at the time of transporting a solid-state imaging device or at the time of assembling the solid-state imaging device with another component. In addition, since a solid-state image sensor falls into the cavity of the wiring substrate, it is possible to protect the solid-state image sensor by means of the wiring substrate.

A solid-state imaging device according to the present invention is characterized in that a step portion having a flat face which is in parallel with the bottom face of the cavity and is provided with the plural connecting terminals thereon is formed on an inner side face of the cavity.

According to the present invention, connecting terminals are formed on a flat face and, also, connecting terminals of a wiring substrate are positioned at not a bottom face side but an opening side of a cavity. Thus, it is unnecessary to insert a tool for wiring connection so as to reach the bottom face of the cavity; therefore, a wiring connecting process can be readily carried out.

A solid-state imaging device according to the present invention is characterized in that at least part of the transparent cover falls into the cavity.

According to the present invention, at least part of a transparent cover falls into a cavity. Thus, it is possible to protect the transparent cover by means of a wiring substrate within a possible range.

A solid-state imaging device according to the present invention is characterized in that a sealant is filled in a space formed between outer side faces of the solid-state image sensor and the transparent cover and the inner side face of the cavity

According to the present invention, it is possible to protect a wiring by means of a sealant and, also, to enhance the entire strength of the solid-state imaging device.

A solid-state imaging device according to the present invention is characterized in that an electronic component which is provided with plural connecting terminals is interposed between the bottom face of the cavity and the solid-state image sensor, and the plural connecting terminals provided on the electronic component are connected with the plural connecting terminal provided on the wiring substrate, respectively through a wiring which falls into the cavity

According to the present invention, an electronic component falls into a cavity of a wiring substrate. Thus, it is possible to protect the electronic component by means of the wiring substrate.

A solid-state imaging device according to the present invention is characterized in that a sealant is filled in a space formed between outer side faces of the electronic component, the solid-state image sensor and the transparent cover and the inner side face of the cavity.

According to the present invention, it is possible to protect wirings by means of a sealant and, also, enhance the entire strength of the solid-state imaging device including an electronic component.

The above and further objects and features of the invention will more fully be apparent from the following detailed description with accompanying drawings.

### BRIEF DESCRIPTION OF THE SEVERAL VIEWS OF THE DRAWINGS

FIG. 1 is a vertical sectional view for illustrating a configuration example of a solid-state imaging device according to Embodiment 1 of the present invention;
FIG. 2 is a plan view for illustrating the configuration example of the solid-state imaging device according to Embodiment 1 of the present invention;
FIG. 3 is a bottom view for illustrating the configuration example of the solid-state imaging device according to Embodiment 1 of the present invention;
FIG. 4 is a bottom view for illustrating a modification of a wiring substrate;
FIG. 5 is a vertical sectional view for illustrating a configuration example of a solid-state imaging device according to Embodiment 2 of the present invention;
FIG. 6 is a plan view for illustrating the configuration example of the solid-state imaging device according to Embodiment 2 of the present invention;
FIG. 7 is a bottom view for illustrating the configuration example of the solid-state imaging device according Embodiment 2 of the present invention;
FIG. 8 is a vertical sectional view for illustrating a configuration example of a solid-state imaging device according to Embodiment 3 of the present invention; and
FIG. 9 is a vertical sectional view for illustrating a configuration example of a solid-state imaging device according to Embodiment 4 of the present invention.

### DETAILED DESCRIPTION OF THE PRESENT INVENTION

Hereinafter, description will be given of a solid-state imaging device according to the present invention on the basis of several embodiments thereof.

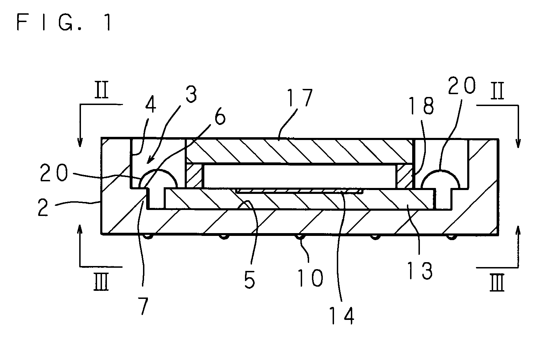

### Embodiment 1 (see FIG. 1 to FIG. 3)

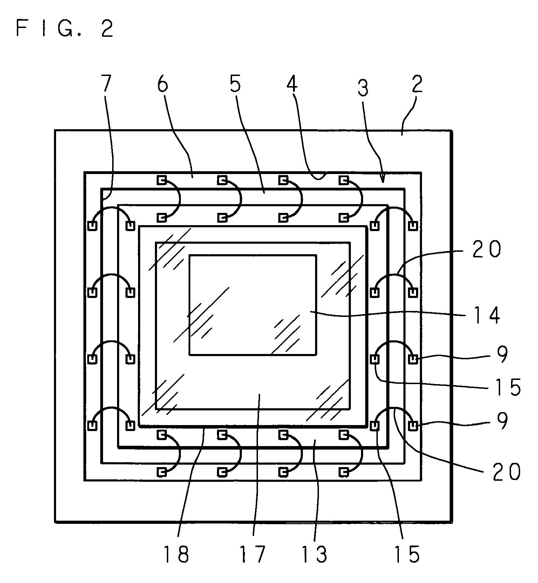

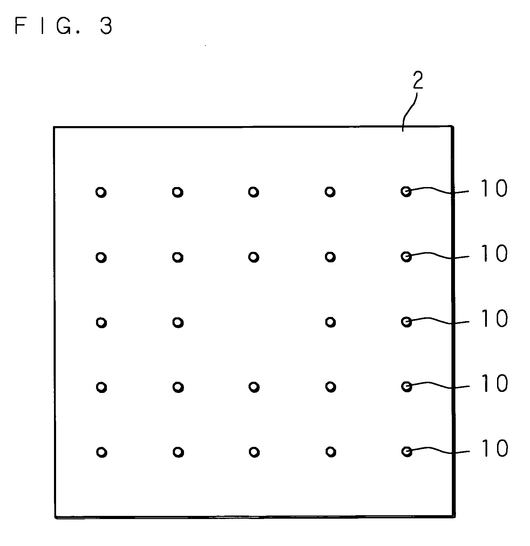

FIG. 1 is a vertical sectional view for illustrating a configuration example of a solid-state imaging device according to Embodiment 1 of the present invention. FIG. 2 is a plan view taken along line II-II of FIG. 1. FIG. 3 is a bottom view taken along line III-III of FIG. 1.

As illustrated in FIG. 1 and FIG. 2, the solid-state imaging device according to the present invention has a wiring substrate 2 on which a conductor wiring (not illustrated) is patterned, has a rectangular shape when being viewed from above, and has an appropriate thickness. One face (hereinafter, referred to as "upper face") of the wiring substrate 2 is provided with a cavity 3 whose bottom face 5 has an appropriate depth with respect to the thickness of the wiring substrate 2 and is in parallel with the upper face of the wiring substrate 2. Herein, an outer shape of the bottom face 5 of the cavity 3 is rectangular shape such that four sides thereof are substantially in parallel with four sides of an outer shape of the wiring substrate 2 when being viewed from above, and a size of the bottom face 5 of the cavity 3 is smaller than the outer shape of the wiring substrate 2 when being viewed from above. In addition, a step portion 7 having a flat face 6 which is in parallel with the bottom face 5 is formed at an entire circumference of an inner side face 4 of the cavity 3. Accordingly, a size of an opening of the cavity 3 to the upper face of the wiring substrate 2 corresponds to a size of an outer periphery of the flat face 6 of the step portion 7, and a size of an outer periphery of the bottom face 5 corresponds to an inner circumference of the flat face 6 of the step portion 7.

Herein, plural connecting terminals 9 are provided on the flat face 6. As illustrated in FIG. 3, plural connecting terminals 10 for connection to an external device are provided on a lower face (i.e., a face on which no cavity 3 is formed) of the wiring substrate 2. Through the wiring substrate 2, the connecting terminals 9 on the flat face 6 are connected with the connecting terminals 10 on the lower face of the wiring substrate 2.

A solid-state image sensor 13 such as a CCD image sensor or a CMOS image sensor is fixedly provided on the bottom face 5 of the cavity 3 of the wiring substrate 2 by means of an adhesive (not illustrated). Herein, an outer shape of the solid-state image sensor 13 is rectangular such that four sides thereof are substantially in parallel with the four sides of the outer shape of the bottom face 5 of the cavity 3 when being viewed from above, and a size of the solid-state image sensor 13 is smaller than the outer shape of bottom face 5 when being viewed from above. Further, one face (hereinafter, referred to as "upper face") of the solid-state image sensor 13 is provided with a pixel area (effective pixel area face) which is rectangular when being viewed from above. Accordingly, in the solid-state image sensor 13 is fixed to the bottom face 5 of the cavity 3 of the wiring substrate 2 at a face on which no pixel area 14 is formed (hereinafter, referred to as "lower face"). Herein, the solid-state image sensor 13 has plural connecting terminals 15 at its circumferential portion. It should be noted that the solid-state image sensor 13 completely falls into the cavity 3.

An outer shape of the pixel area 14 of the solid-state image sensor 13 is rectangular such that four sides thereof are substantially in parallel with the four sides of the solid-state image sensor 13 when being viewed from above, and a size of the pixel area 14 of the solid-state image sensor 13 is smaller than the outer shape of the solid-state image sensor 13 when being viewed from above.

A rectangular transparent cover 17, which is made of, for example, a glass plate and is slightly larger than the pixel area 14 when being viewed from above, is fixed so as to oppose the pixel area 14 of the solid-state image sensor 13. More specifically, the transparent cover 17 is fixed to a rectangular frame-like portion on the outside of the pixel area 14 of the upper face of the solid-state image sensor 13, through an adhesive layer 18 made of, for example, an acrylic adhesive. Herein, the adhesive layer 18 is provided on an entire circumferential portion of the transparent cover 17. Accordingly, the pixel area 14 of the solid-state image sensor 13 is sealed with the transparent cover 17 and the adhesive layer 18 and, therefore, is protected from dust. Herein, the depth of the cavity 3, the thickness of the solid-state image sensor 13, and the thickness of the adhesive layer 18 are determined, respectively, such that at least part of the transparent cover 17 in thickness falls into the cavity 3.

Each of the connecting terminals 9 provided on the flat face 6 of the wiring substrate 2 is connected with each of the connecting terminals 15 provided on the solid-state image sensor 13 through a wiring 20 which falls into the cavity 3, in other words, which does not protrude from the upper face of the wiring substrate 2.

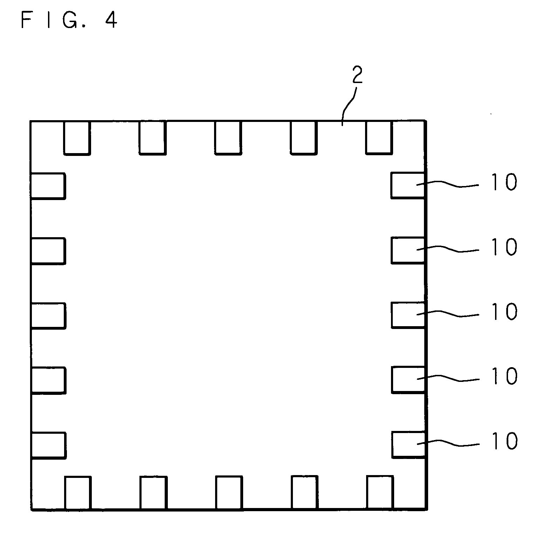

FIG. 4 is a bottom view for illustrating a modification of the wiring substrate 2. In an example illustrated in FIG. 4, plural connecting terminals 10, each of which is used for connection with an external device and is rectangular when being viewed from above, are provided on a circumferential portion of the bottom face of the wiring substrate 2. As in the aforementioned description, through the wiring substrate 2, each of the connecting terminals 10 illustrated in FIG. 4 is connected with each of the connecting terminals 9 provided on the flat face 6 of the wiring substrate 2.

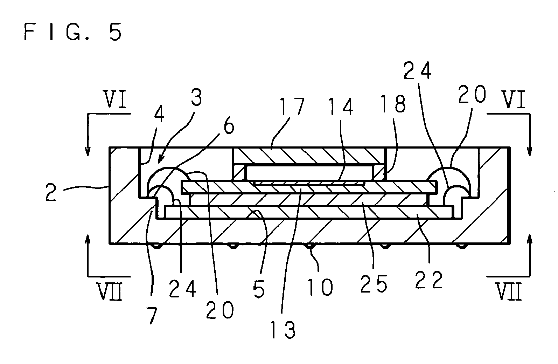

### Embodiment 2 (see FIG. 5 to FIG. 7)

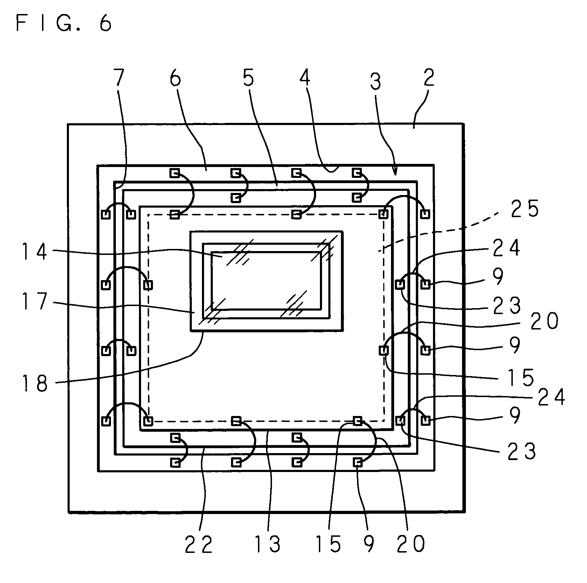

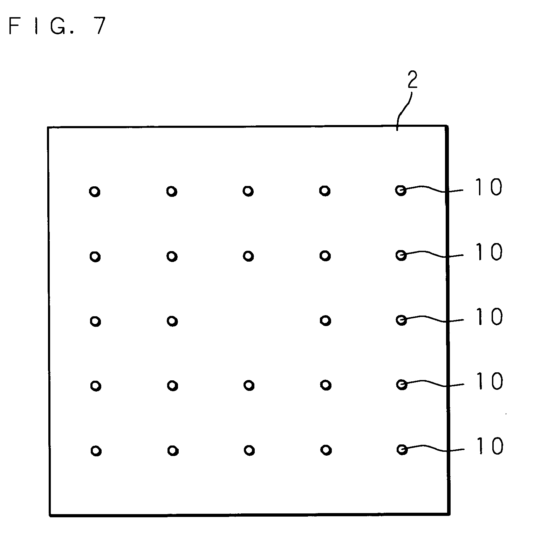

FIG. 5 is a vertical sectional view for illustrating a configuration example of a solid-state imaging device according to Embodiment 2 of the present invention. FIG. 6 is a plan view taken along line VI-VI of FIG. 5. FIG. 7 is a bottom view taken along line VII-VII of FIG. 5.

As shown in FIG. 5 and FIG. 6, an electronic component 22 and a spacer 25 each of which is rectangular when being viewed from above are interposed between the bottom face 5 of the cavity 3 of the wiring substrate 2 and the solid-state image sensor 13, and are fixed by means of an adhesive (not illustrated). The other configuration is identical to that in Embodiment 1.

The electronic component 22 includes a digital signal processor, a drive circuit for a CCD image sensor, a resistor of a built-on filtering circuit, a capacitor, and the like. The electronic component 22 is provided with plural connecting terminals 23. Each of the connecting terminals 23 is connected with each of the connecting terminals 9 provided on the flat face 6 of the cavity 3 of the wiring substrate 2 through a wiring 24 which falls into the cavity 3, in other words, which does not protrude from the upper face of the wiring substrate 2. Also in Embodiment 2, the depth of the cavity 3, the thickness of the electronic component 22, the thickness of the spacer 25, the thickness of the solid-state image sensor 13, and the thickness of the adhesive layer 18 are determined, respectively, such that at least part of the transparent cover 17 falls into the cavity 3.

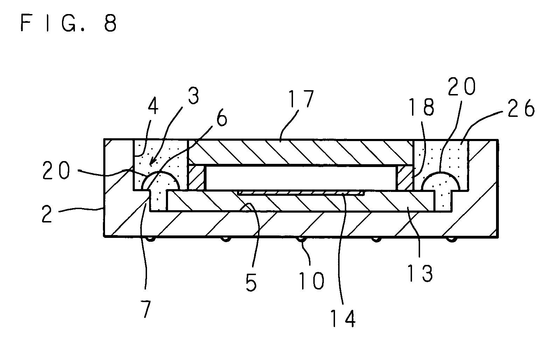

### Embodiment 3 (see FIG. 8)

FIG. 8 is a vertical sectional view for illustrating a configuration example of a solid-state imaging device according to Embodiment 3 of the present invention. As illustrated in FIG. 8, in Embodiment 3, a void in the cavity 3 is filled with a sealant 26, in addition to the configuration in Embodiment 1 illustrated in FIG. 1. More specifically, a space formed between the outer side faces of the solid-state image sensor 13, adhesive layer 18 and transparent cover 17 and the inner side face 4 (including the inner side face and the flat face 6 of the step portion 7) of the cavity 3 is filled with the sealant 26 made of synthetic resin. The other configuration is identical to that in Embodiment 1. The sealant 26 is used for the purpose of intending to protect the wiring 20 and, also, enhancing the entire strength of the solid-state imaging device.

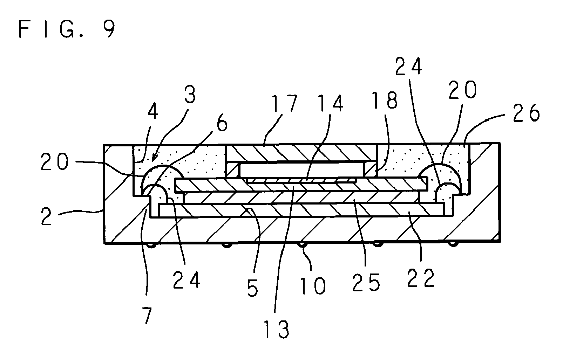

### Embodiment 4 (see FIG. 9)

FIG. 9 is a vertical sectional view for illustrating a configuration example of a solid-state imaging device according to Embodiment 4 of the present invention. As illustrated in FIG. 9, in Embodiment 4, a void in the cavity 3 is filled with the sealant 26, in addition to the configuration in Embodiment 2 illustrated in FIG. 5. More specifically, a space formed between the outer side faces of the electronic component 22, spacer 25, solid-state image sensor 13, adhesive layer 18 and transparent cover 17 and the inner side face 4 (including the inner side face and the flat face 6 of the step portion 7) of the cavity 3 is filled with the sealant 26 made of synthetic resin. The other configuration is identical to that in Embodiment 2. The sealant 26 is used for the purpose of intending to protect the wirings 20 and 24 and, also, enhancing the entire strength of the solid-state imaging device.

It is needless to say that the modification of the wiring substrate 2 illustrated in FIG. 4 can be applied to the wiring substrate 2 in Embodiments 2, 3 and 4 as a modification of the wiring substrate 2.

## Claims

1. A solid-state imaging device comprising: a wiring substrate (2); a solid-state image sensor (13) fixed to said wiring substrate (2); and a transparent cover (17) fixed to said solid-state image sensor (13) so as to oppose a pixel area (14) of said solid-state image sensor (13);
**characterized in that**
a cavity (3) which is provided with, at an inner face thereof, plural connecting terminals (9) is formed on one face of said wiring substrate (2),
said solid-state image sensor (13) is provided with plural connecting terminals (9), and is fixed to a bottom face (5) of said cavity (3) in a state where said solid-state image sensor (13) falls into said cavity (3), and
said plural connecting terminals (9) provided in said cavity (3) are connected with said plural connecting terminals (15) provided on said solid-state image sensor (13), respectively through a wiring (20) which falls into said cavity (3).

2. The sold-state imaging device as set forth in claim 1, **characterized in that** a step portion (7) having a flat face (6) which is in parallel with said bottom face (5) of said cavity (3) and is provided with said plural connecting terminals (9) thereon is formed on an inner side face (4) of said cavity (3).

3. The solid-state imaging device as set forth in claim 1 or 2, **characterized in that** at least part of said transparent cover (17) falls into said cavity (3).

4. The solid-state imaging device as set forth in any one of claims 1 through 3, **characterized in that** a sealant (26) is filled in a space formed between outer side faces of said solid-state image sensor (13) and said transparent cover (17) and said inner side face (4) of said cavity (3).

5. The solid-state imaging device as set forth in any one of claims 1 through 3, **characterized in that**
an electronic component (22) which is provided with plural connecting terminals (23) is interposed between said bottom face (5) of said cavity (3) and said solid-state image sensor (13), and
said plural connecting terminals (23) provided on said electronic component (22) are connected with said plural connecting terminal (9) provided on said wiring substrate (2), respectively through a wiring (24) which falls into said cavity (3).

6. The solid-state imaging device as set forth in claim 5, **characterized in that** a sealant (26) is filled in a space formed between outer side faces of said electronic component (22), said solid-state image sensor (13) and said transparent cover (17) and said inner side face (4) of said cavity (3).
